# EUROPÄISCHE PATENTANMELDUNG

(11) **EP 0 803 887 A2**
(43) Veröffentlichungstag der Anmeldung: **29.10.1997**
(21) Anmeldenummer: 97106685.7
(22) Anmeldetag: 23.04.1997
(51) Int. Cl.: H01H 13/70

(54) **Folientastatur**

(30) Priorität: 25.04.1996 DE 19616451
(71) Anmelder: WÜRTH ELEKTRONIK GmbH & Co. KG, D-74676 Niedernhall (DE)
(72) Erfinder: Kallee, Werner, 74177 Bad Friedrichshall (DE)
(74) Vertreter: Patentanwälte Ruff, Beier, Schöndorf und Mütschele

(57) **Zusammenfassung**

Bei einer Folientastatur, die auf ihrer dem Benutzer zugewandten Seite Bedienelemente und gegebenenfalls Anzeigeelemente aufweist, wird vorgeschlagen, die zur Ansteuerung und Auswertung der Tastatureingaben erforderlichen elektronischen Bauteile unmittelbar an der Rückseite der Frontplatte anzubringen, die vorzugsweise als Leiterplatte ausgebildet ist. Die Befestigung kann an der Rückseite der Frontplatte entweder durch Auflöten in SMD-Technik oder in Einpreßtechnik erfolgen.

In Einpreßtechnik können auch die rein mechanischen Funktionsteile angebracht werden, die zur Anbringung der Folientastatur an einem Gerät dienen.

## Beschreibung

Die Erfindung geht aus von einer Folientastatur.

Folientastaturen sind Einrichtungen, die insbesondere in einem industriellen Umfeld verwendet werden, also in einer Umgebung, die nicht staubfrei oder schmutzfrei ist.

Folientastaturen enthalten Bedienelemente, die durch Druck oder Berührung bedient werden, sowie gegebenenfalls Anzeigemittel, wobei es sich beispielsweise um durchsichtige oder durchscheinende Felder handeln kann, hinter denen Leuchtdioden, Displays o. dgl. angeordnet sind.

Die bekannten Folientastaturen enthalten eine Frontplatte, die in der Regel aus Aluminium besteht und an deren Frontseite die Bedienelemente angeordnet sind.

Mit Hilfe von Abstandselementen ist dann hinter der Frontscheibe eine Leiterplatte angeordnet, auf der die elektronischen Elemente vorhanden sind, die zum Ansteuern der Tastatur und zum Auswerten von Tastaturangaben nötig sind.

An einer nochmals weiteren mit Abstandsmitteln befestigten Platte sind dann die Stromversorgungselemente, ein Netzteil o. dgl. angeordnet.

Diese Art von Folientastaturen hat den Nachteil, daß ihr Aufbau zeitaufwendig und kompliziert ist und daß sie eine relativ große Bautiefe benötigen.

Der Erfindung liegt die Aufgabe zugrunde, eine Folientastatur zu schaffen, die sich sehr leicht herstellen und zusammensetzen läßt und die eine geringe Bautiefe benötigt.

Zur Lösung dieser Aufgabe schlägt die Erfindung eine Folientastatur mit den im Anspruch 1 aufgeführten Merkmalen vor. Weiterbildungen der Erfindung sind Gegenstand von Unteransprüchen.

Bei den an der Rückseite der Folientastatur anzuordnenden Bauteilen kann es sich um rein elektronische Bauteile, z. B. Schaltkreise, handeln, oder auch um Stecker, Steckerleisten, Sockel für Platinen o. dgl. Nach der Erfindung werden alle für die Tastatur erforderlichen elektronischen Bauteile unmittelbar hinter der Frontplatte an dieser befestigt. Die Befestigung kann beispielsweise in SMD-Technik erfolgen, was ein übliches Verfahren zur Anbringung kleiner elektronischer Bauteile ist.

Stecker, Steckerleisten oder sonstige Bauteile, die nicht angelötet werden, sondern mechanisch mit der Frontplatte verbunden werden, werden erfindungsgemäß in Einpreßtechnik angebracht. Dies bedeutet, daß sie in durchgehende oder Sacklochbohrungen der Frontplatte so eingepreßt werden, daß sie nicht über die Vorderseite der Frontplatte vorstehen. Dort wird nämlich eine Abdeckfolie aufgebracht, die mit Ausnahme der Knackfrösche glatt anliegen soll.

Erfindungsgemäß besteht die Frontplatte nicht mehr aus Aluminium, sondern ist als Leiterplatte ausgebildet.

Die zur Anbringung der Frontplatte an einem Gerät erforderlichen rein mechanischen Bauteile können ebenfalls in Einpreßtechnik an der Frontplatte befestigt werden. Hierbei kann es sich beispielsweise um Distanztürme o. dgl. handeln.

Erfindungsgemäß ist auch bei der Folientastatur vorgesehen, daß die Stromversorgung auf einer getrennten Platte erfolgt, die mit der Frontplatte über mechanische Distanzelemente, beispielsweise Distanztürme verbunden ist.

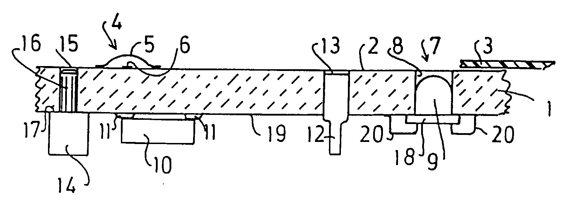

Weitere Merkmale, Einzelheiten und Vorzüge ergeben sich aus den Patentansprüchen, deren Wortlaut durch Bezugnahme zum Inhalt der Beschreibung gemacht wird, der folgenden Beschreibung einer bevorzugten Ausführungsform der Erfindung sowie anhand der Zeichnung. Hierbei zeigt die einzige Zeichnungsfigur schematisch einen Querschnitt durch eine als Leiterplatte ausgebildete Frontplatte einer Folientastatur.

In der Figur ist ein Teilschnitt durch eine Folientastatur dargestellt, bei der die die Folientastatur aufnehmende Frontplatte 1 als Leiterplatte ausgebildet ist. Die in der Figur obere Seite 2 der Frontplatte 1 bildet die dem Benutzer zugewandte Seite. Sie ist als ebene Fläche ohne Vorsprünge ausgebildet und wird in fertiggestelltem Zustand von einer nur angedeuteten Folie 3 abgedeckt. Auf die ebene Vorderseite 2 der Leiterplatte 1 werden Bedienelemente 4 wie im dargestellten Beispiel ein Knackfrosch 5 angebracht. Es handelt sich hier um ein verbiegbares Metallteil, das nur etwas über die Oberfläche vorsteht und durch Drücken in Kontakt mit dem darunterliegenden Kontaktelement 6 gebracht werden kann. Auch die Knackfrösche 5 liegen unter der Folie 3.

Zusätzlich zu den Bedienelementen 4, von denen als Beispiel nur ein einziges dargestellt ist, enthält die Frontplatte ein Anzeigemittel 7, das von einer in einer durchgehenden Öffnung 8 angeordneten Leuchtdiode 9 gebildet wird.

Es könnte sich auch um ein Anzeigeelement handeln, das hinter der Frontplatte 1 angeordnet ist und das durch eine Öffnung 9 von vorne sichtbar ist. Die Folie 3 weist in diesem Bereich ein Fenster auf, das durchsichtig oder durchscheinend sein kann.

Die Folientastatur soll durch Betätigen eines Betätigungselements 4 bestimmte Vorgänge auslösen. Dies geschieht in der Regel dadurch, daß Tastendrücke in einer zugeordneten Elektronik codiert werden, so daß dann als Ausgabe ein in einer bestimmten Weise codiertes Signal vorliegt. Die zu dieser Auswert- und Ansteuerelektronik gehörenden elektronischen Bauteile werden in der vereinfachten Darstellung der Figur durch ein einziges elektronisches Bauteil 10 repräsentiert. Bei diesem elektronischen Bauteil 10 handelt es sich um eine integrierte Schaltung in SMD-Bauweise, die in SMD-Technik auf Lötstellen 11 unmittelbar an der Rückseite der Frontplatte 1 aufgelötet wird.

Zur Anbringung von Leitungen oder elektronischen Bauteilen, die einen Sockel benötigen, können mechanische Hilfselemente wie beispielsweise ein Steckerstift 12 an der Rückseite der Frontplatte 1 angeordnet werden, die in Einpreßtechnik mit der Frontplatte 1 verbunden werden. Dies bedeutet, daß das Bauteil in ein Loch 13 der Frontplatte 1 eingepreßt wird, wobei die Einpressung gleichzeitig eine mechanische Festlegung als auch, sofern erforderlich, eine Kontaktierung mit den kontaktierten Wänden des Lochs 13 herstellt. Der Steckerstift 12 ist hier nur als ein mögliches Bauteil angegeben.

Zur mechanischen Anbringung an einer weiteren, in der Figur nicht dargestellten, die Stromversorgung aufnehmenden Platte dienen Abstandstürme 14, die also eine rein mechanische Funktion übernehmen. Der Abstandsturm 14 ist ähnlich wie der Steckerstift 12 in ein Loch 15 der Leiterplatte 1 eingepreßt. Er enthält zu diesem Zweck einen dem Durchmesser des Lochs 15 entsprechenden zylindrischen mit einer Riefelung versehenen Ansatz 16. Der Ansatz 16 weist einen gegenüber dem sonstigen Abstandsturm 14 verringerten Durchmesser auf, so daß eine Anlageschulter 17 gebildet wird. Diese Anlageschulter 17 begrenzt die durch das Einpressen bewirkte Eindringbewegung des Ansatzes 16 in die Leiterplatte. Der Ansatz 16 ist derart auf die Leiterplatte 1 abgestimmt, daß sein freies Ende nicht über die Vorderseite 2 der Leiterplatte 1 übersteht.

In ähnlicher Weise wie der Abstandsturm 14 ist auch die Leuchtdiode 9 angeordnet, die einen flanschartigen Rand 18 aufweist, mit dem sie an der Rückseite 19 der Frontplatte 1 anliegt. Da auf die Leuchtdiode 9 keine Kräfte ausgeübt werden, braucht sie nicht eingepreßt zu werden, sondern liegt nur in dem Loch 8. Ihre Befestigung kann allein aufgrund der beiden Zuleitungsdrähte 20 erfolgen.

Die von der Erfindung vorgeschlagene Folientastatur läßt sich sehr einfach herstellen, da die Frontplatte wie eine übliche Leiterplatte bestückt werden kann. Sie besitzt außerdem aufgrund des Wegfalls der Zwischenplatine eine geringe Bautiefe.

## Patentansprüche

1. Folientastatur, mit
1.1 einer Frontplatte (1), deren
1.1.1 Vorderseite (2) einem Benutzer zugewandt ist und
1.1.2 Bedienungselemente (4) und
1.1.3 gegebenenfalls Anzeigemittel (7) aufweist,
1.2 elektrischen Funktionselementen (10) zur Ansteuerung der Tastatur und Auswertung der Tastatureingaben, die
1.2.1 auf der Rückseite (19) der Frontplatte (1) angeordnet und
1.2.2 direkt an der Frontplatte (1) befestigt sind, sowie mit
1.3 mechanischen Funktionselementen, die
1.3.1 auf der Rückseite (19) der Frontplatte (1) angeordnet und
1.3.2 direkt an dieser befestigt sind.

2. Folientastatur nach Anspruch 1, bei der Bauteile (12, 14) in Einpreßtechnik in Löchern (13, 15) der Frontplatte (1) befestigt sind.

3. Folientastatur nach Anspruch 1 oder 2, bei der Bauteile (10) in SMD-Technik an der Frontplatte (1) befestigt sind.

4. Folientastatur nach einem der vorhergehenden Ansprüche, mit mindestens einem Distanzturm zur Anbringung einer die Stromversorgung bzw. die Stromzuführung für die Frontplatte (1) aufweisenden Grundplatte an der Frontplatte (1).

5. Folientastatur nach einem der vorhergehenden Ansprüche, bei der die Frontplatte (1) als Leiterplatte ausgebildet ist.
